# EUROPEAN PATENT APPLICATION

(11) **EP 2 790 311 A1**
(43) Date of publication of application: **15.10.2014**
(21) Application number: 14162947.7
(22) Date of filing: 31.03.2014
(51) Int. Cl.: H02M 7/00, H01G 2/08, H05K 7/20

(54) **Immersion cooled capacitor for power electronics convertor**

(30) Priority: 10.04.2013 US 201313860265
(71) Applicant: Hamilton Sundstrand Corporation, Charlotte, NC 28217 (US)
(72) Inventor: Parkin, Joshua Scott, Loves Park, IL 61111 (US); Courtney, Christopher J, Janesville, WI 53545 (US)
(74) Representative: Hall, Matthew Benjamin

(57) **Abstract**

A power electronics convertor (100) is disclosed which includes a hermetically sealed housing (112), a dielectric cooling fluid (114) contained in the housing, and a bank of capacitive elements (16) disposed within the housing and submerged in the cooling fluid, wherein each capacitive element is wound about a hollow aluminum core (18) forming an open interior region (15) within the center of the capacitive element that is dimensioned and configured to optimize heat transfer between the capacitive element and the cooling fluid and reduce thermal stress in the capacitor (10).

## Description

The subject invention relates to bulk capacitors, and more particularly, to an immersion cooled bulk film capacitor for use in aerospace power electronics converter equipment.

Power conversion equipment requires the rapid switching of large currents by power electronic semiconductor devices. Typically, in power convertor circuits, reactive current is provided by a bank of bulk capacitors, as disclosed for example in U.S. Patent No. 5,729,450 to Dimino et al. Bulk film capacitors are an important aspect in any aerospace power electronic converter.

Often these capacitors are sized by their current rating and thus become thermally limited due to excessive heating and internal hot spots. Unless properly designed and controlled, high rates of heat generation can result in high operating temperatures for electronic equipment. This will jeopardize its safety and reliability. Therefore, thermal control has become increasingly important in the design and operation of power conversion equipment.

Several cooling techniques are commonly used in electronic equipment. These include conduction cooling, natural convection and radiation cooling, forced-air cooling, liquid cooling and immersion cooling. The immersion cooling technique is the most reliable, since it does not involve any penetration into the electronic enclosure and the component resides in a completely sealed liquid environment. The subject application employs the technique of immersion cooling to optimize heat transfer and reduce thermal stress in a uniquely constructed bulk film capacitor.

The subject invention is directed to a power electronics converter and more particularly to a new and useful immersion cooled capacitor for use in power electronics converters. The power electronics convertor includes a housing, a cooling liquid contained within the housing, and at least one capacitive element disposed within the housing and submerged in the cooling liquid.

Preferably, there is a bank of capacitive elements disposed within the housing and submerged in the cooling liquid. Each capacitive element in the bank of capacitive elements has an open interior region configured to optimize heat transfer between the capacitive element and the cooling liquid and reduce thermal stress in the capacitor.

The housing of the power electronics convertor is hermetically sealed and the cooling liquid is a non-conductive liquid, such as for example, a fluorocarbon fluid. Each capacitive element is wound about a thermally conductive hollow core forming the open interior region of the capacitive element. In one aspect of the invention, the hollow core of the capacitive element has a smooth interior surface finish. Alternatively, the hollow core of the capacitive element has a roughened interior surface finish to help initiate nucleated boiling of the cooling fluid.

The capacitive element may be an inductively wound element or a non-inductively wound element. In either case, the capacitive element is configured with two alternating layers of metallized foil and two alternating layers of insulative film, wherein one foil layer provides a positive terminal for the capacitor and the other foil layer provides a negative terminal for the capacitor. Those skilled in the art should readily appreciate that although the two terminals are referred to herein as positive and negative, bulk film capacitors are typically not polarized.

In the case of the non-inductively wound element, end portions of one foil layer extend from one end of the capacitive element and end portions of the other foil layer extend from an opposed end of the capacitive element. Preferably, the end portions of the respective foil layers are joined to one another by an end connection, and a terminal tab is provided at each end connection, whereby one end terminal defines a positive terminal for the capacitor and the other terminal defines a negative terminal for the capacitor.

The following clauses set out features of the invention which may not presently be claimed in this application but which may form the basis for future amendment or a divisional application:
1. A power electronics convertor comprising:
   a hermetically sealed housing;
   a fluorocarbon cooling fluid contained in the housing;
   a bank of capacitive elements disposed within the housing and submerged in the cooling fluid, wherein each capacitive element in the bank is wound about a thermally conductive hollow core defining an open interior region within the capacitive element that is dimensioned and configured to optimize heat transfer between the capacitive element and the cooling fluid.
2. A power electronics convertor as recited in clause 1, wherein the hollow core of each capacitive element has a smooth interior surface finish.
3. A power electronics convertor as recited in clause 1, wherein the hollow core of each capacitive element has a roughened interior surface finish.
4. A power electronics convertor as recited in clause 1, 2 or 3, wherein each capacitive element is an inductively wound element.
5. A power electronics convertor as recited in clause 1, 2 or 3, wherein each capacitive element is a non-inductively wound element.
6. An immersion cooled capacitor for a power electronics convertor comprising:
   a capacitive element wound about a hollow aluminum core forming an open interior region within the center of the capacitive element that is dimensioned and configured to optimize heat transfer between the capacitive element and a cooling fluid flowing therethrough.
7. An immersion cooled capacitor for a power electronics convertor as recited in clause 6, wherein the capacitive element is an inductively wound element.
8. An immersion cooled capacitor for a power electronics convertor as recited in clause 6, wherein the capacitive element is a non-inductively wound element.
9. A immersion cooled capacitor for a power electronics convertor as recited in clause 6, 7 or 8, wherein the hollow core has a smooth interior surface finish.
10. A immersion cooled capacitor for a power electronics convertor as recited in clause 6, 7 or 8, wherein the hollow core has a roughened interior surface finish.

These and other features of the immersion cooled capacitor of the subject invention and the manner in which it is employed within a power electronics convertor will become more readily apparent to those having ordinary skill in the art from the following enabling description of the preferred embodiments of the subject invention taken in conjunction with the several drawings described below.

So that those skilled in the art to which the subject invention appertains will readily understand how to make and use the immersion cooled capacitor of the subject invention without undue experimentation, preferred embodiments thereof will be described in detail herein below by way of example only, and with reference to certain figures, wherein:
Fig. 1 is a perspective view of a power electronics convertor constructed in accordance with a preferred embodiment of the subject invention, with the wall of the hermetically sealed housing cut away to show a bank of immersion cooled capacitors submerged in a dielectric cooling liquid contained within the housing;
Fig. 2 is a perspective view of an immersion cooled capacitor constructed in accordance with a preferred embodiment of the subject invention, which includes an open interior region that allows the dielectric cooling liquid to flow therethrough;
Fig. 3 is a cross-sectional view of the immersion cooled capacitor disposed within the housing of the power electronics convertor, taken along line 3-3 of Fig. 1;
Fig. 4 is an illustration of the alternating foil and film layers of an inductively wound capacitor constructed in accordance with a preferred embodiment of the subject invention; and
Fig. 5 is an illustration of the alternating foil and film layers of a non-inductively wound capacitor constructed in accordance with a preferred embodiment of the subject invention.

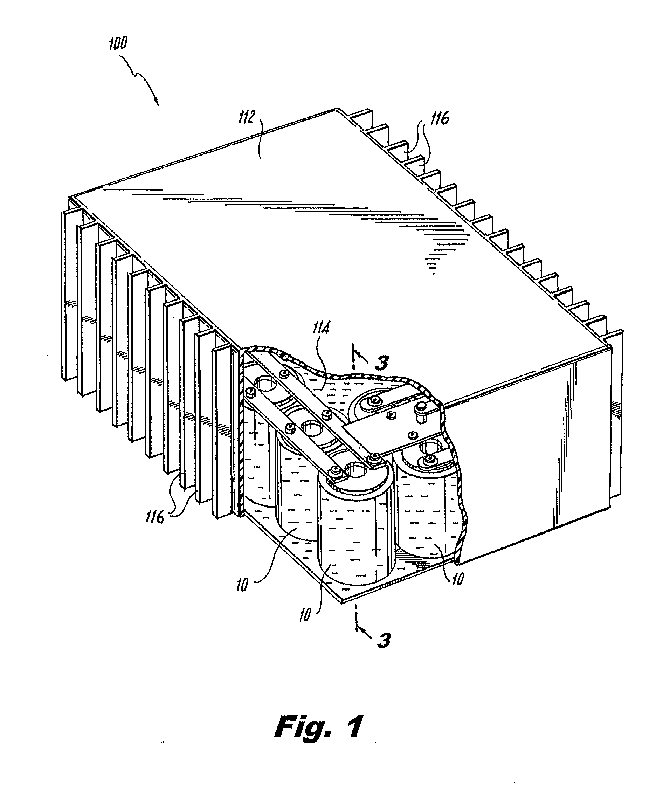

Referring now to the drawings, wherein like reference numerals identify similar structural features or aspects of the subject invention, there is illustrated in Fig. 1 a power electronics converter 100 containing, among other things, a bank of immersion cooled bulk film capacitors constructed in accordance with a preferred embodiment of the subject invention and each one designated generally by reference numeral 10. Those skilled in the art will readily appreciate that the power electronics convertor 100 will also include a number of switches, magnets and other components, all of which generate a substantial amount of heat, affecting the performance reliability of the convertor.

Referring to Fig. 1, the power electronics convertor 100 includes a hermetically sealed housing 112 containing a cooling liquid 114 and having external cooling fins 116. The cooling liquid 114 is a non-conductive liquid, such as for example, a fluorocarbon fluid. A preferred dielectric cooling fluid is 3M's Fluorinert™ FC-72, which is thermally and chemically stable, compatible with sensitive materials and non-flammable. Key properties of Fluorinert™ FC-72 include: a typical boiling point of 56°C; a dielectric strength of 38 KV (0.01 inch gap); and a dielectric constant (1KHz) of 1.76.

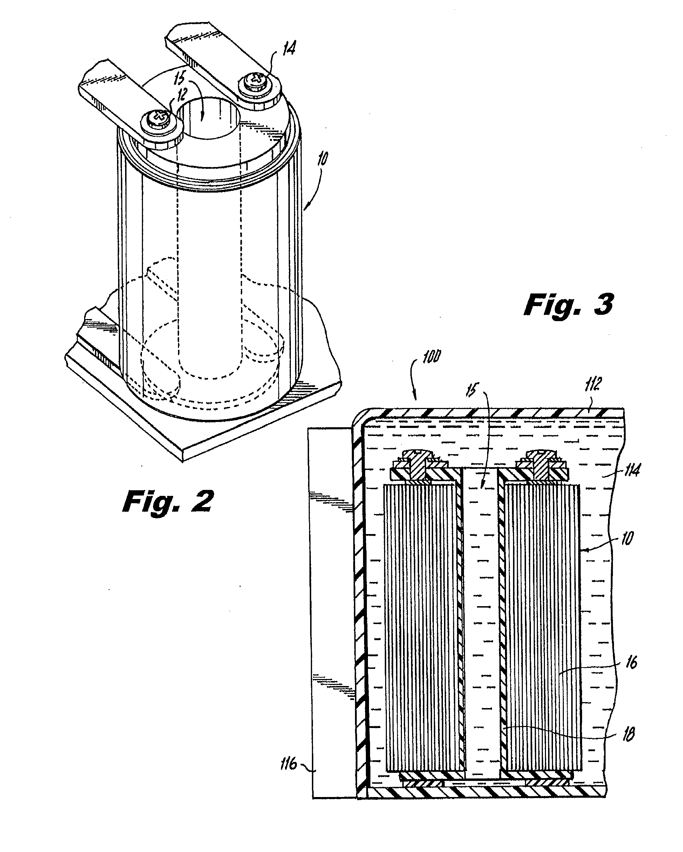

Referring to Fig. 2, each of the immersion cooled capacitors 10 within the bank of capacitors define a single capacitive cell with positive and negative terminals 12, 14. Those skilled in the art should readily appreciate that although the two terminals 12, 14 are referred to herein as positive and negative, bulk film capacitors are typically not polarized.

As best seen in Fig. 3, each capacitor 10 includes a capacitive element 16 having an open interior region 15 that is dimensioned and configured to optimize heat transfer between the capacitive element 16 and the cooling liquid 114. The open interior region 15 allows the dielectric cooling liquid 114 to move through the capacitive element 16 and initiate nucleated boiling at the center of the component within the sealed housing 112, where a significant amount of heat is generated.

The capacitive element 16 is cooled through nucleated boiling of the cooling liquid 114 and will have a heat transfer coefficient of about 15,000 W/m²K, as compared to 5 W/m²K with natural convection air. In operation, heat dissipated into the cooling liquid 114 from the capacitive element 16 is transferred to the walls of the housing 112, and then to the external fins 116. That heat can then be readily removed by external cooling means, such as, for example, by a cooling fan.

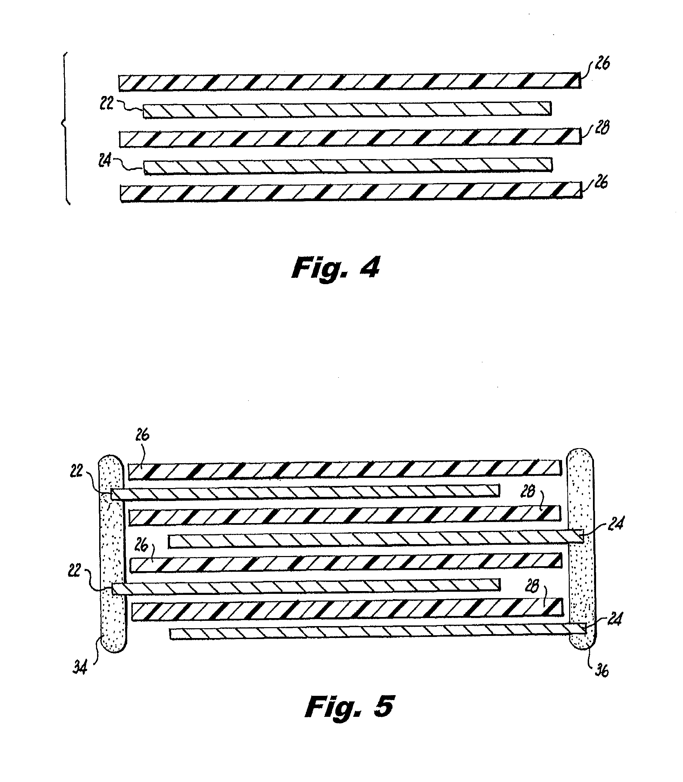

With continuing reference to Figs. 2 and 3, each capacitive element 16 consists of alternating layers of metallized foil and insulative film that are spirally wound about a thermally conductive hollow tubular core 18, as described in more detail below with reference to Figs. 4 and 5. The hollow tubular core 18 forms the open interior region of the capacitive element 16. Preferably, the hollow core 18 is made from aluminum, although any thermally conductive material can be used. Those skilled in the art will readily appreciate that the core of a wound capacitor is typically formed by a solid post, as disclosed for example in U.S. Patent No. 6,620,366 to Sagal.

The high heat transfer coefficient of 3M's Fluorinert™ FC-72 and its ability to move through very small passages leads to the need for only a small diameter passage through the hollow core 18 of the capacitor 16. This small core passage of core member 18 effectively enables the removal of heat from the capacitor element 16 and maintains the volumetric density thereof. The size of the bore hole of core member 18 can vary depending upon the application, but it is typically small in diameter relative to the overall diameter of the capacitor 16.

In one embodiment of the subject invention, the hollow core 18 has a smooth interior surface finish. In another embodiment of the subject invention, the hollow core 18 has a roughened interior surface finish to help initiate nucleated boiling of the cooling liquid 114 as it passes through the central passage of the hollow core 18.

The capacitive element 16 can be formed as an inductively wound element as illustrated in Fig. 4, or a non-inductively wound element as illustrated in Fig. 5. In either case, one of the foil layers provides a positive terminal for the capacitor 10 and the other foil layer provides a negative terminal for the capacitor 10.

In the case of the inductively wound element shown in Fig. 4, the alternating layers include two metallic foil layers 22, 24 and two insulating film layers 26, 28. Flying leads or tabs (not shown) are inserted between the film/foil layers to create the positive and negative terminals of the capacitor 10.

In the case of the non-inductively wound element shown in Fig. 5, end portions of foil layer 22 extend from one end of the capacitive element 16 and end portion of the other foil layer 24 extend from the opposed end of the capacitive element 16. The end portions of the respective foil layers 22, 24 are joined to one another by end connections 34, 36.

Preferably, the end connections 34, 36 are formed by applying a conductive spray. For this application the hollow core 18 is first covered and then the spray is applied. After the spray has been applied, the coolant channel of the core 18 is uncovered. Thereafter, terminal tabs (now shown) are inserted into the end connections 34, 36 on either side of the capacitive element 16.

Those skilled in the art will readily appreciate that there is no need to isolate the hollow aluminum core 18, as typically the first layer in the stack is an insulative film layer. Nevertheless, if the first layer in the stack was a foil layer, it would not affect the capacitor since the hollow aluminum core 18 would only make contact with a single foil layer.

While the immersion cooled capacitor 10 of the subject invention has been shown and described with reference to preferred embodiments, those skilled in the art will readily appreciate that various changes and/or modifications may be made thereto without departing from the scope of the subject invention as defined by the appended claims.

## Claims

1. A power electronics convertor (100) comprising:
a housing (112);
a cooling liquid (114) contained in the housing;
at least one capacitive element (16) disposed within the housing and submerged in the cooling liquid, wherein the capacitive element has an open interior region (15) configured to optimize heat transfer between the capacitive element and the cooling liquid.

2. A power electronics convertor (100) as recited in Claim 1, wherein the housing is hermetically sealed.

3. A power electronics convertor (100) as recited in Claim 1 or 2, wherein the cooling liquid (114) is a non-conductive liquid.

4. A power electronics convertor (100) as recited in Claim 3, wherein the cooling liquid (114) is a fluorocarbon fluid.

5. A power electronics convertor (100) as recited in Claim 1, 2 or 3, wherein the at least one capacitive element (16) is wound about a thermally conductive hollow core (18) forming the open interior region (15) of the capacitive element.

6. A power electronics convertor (100) as recited in Claim 5, wherein the hollow core (18) has a smooth interior surface finish.

7. A power electronics convertor (100) as recited in Claim 5, wherein the hollow core (18) has a roughened interior surface finish.

8. A power electronics convertor (100) as recited in any preceding claim, wherein the at least one capacitive element (16) is an inductively wound element.

9. A power electronics convertor (100) as recited in any preceding claim, wherein the at least one capacitive element (16) is a non-inductively wound element.

10. A power electronics convertor (100) as recited in any preceding claim, wherein the at least one capacitive element (16) is configured with two alternating layers of metallized foil (22, 24) and two alternating layers of insulative film (26, 28), wherein one foil layer provides a positive terminal for the capacitor (10) and the other foil layer provides a negative terminal for the capacitor.

11. A power electronics convertor (100) as recited in Claim 10, wherein end portions of one foil layer (22) extend from one end of the capacitive element (16) and end potions of the other foil layer (24) extend from an opposed end of the capacitive element.

12. A power electronics convertor (100) as recited in Claim 11, wherein the end portions of the respective foil layers (22, 24) are joined to one another by end connection (34, 36).

13. A power electronics converter (100) as recited in any of Claims 5 to 12, wherein the hollow core (18) defines an open interior region (15) within the capacitive element that is dimensioned and configured to optimize heat transfer between the capacitive element (16) and the cooling fluid (114).

14. A power electronics convertor (100) as recited in any preceding claim, further comprising a bank of capacitive elements (16) disposed within the housing (112) and submerged in the cooling fluid (114), wherein each capacitive element in the bank is wound about a thermally conductive hollow core (18) defining an open interior region (15) within the capacitive element that is dimensioned and configured to optimize heat transfer between the capacitive element and the cooling fluid.

15. An immersion cooled capacitor (10) for a power electronics convertor (100) as recited in any preceding claim, comprising a capacitive element (16) wound about a hollow aluminum core (18) forming an open interior region (15) within the center of the capacitive element that is dimensioned and configured to optimize heat transfer between the capacitive element and a cooling fluid (114) flowing therethrough.
